# FASCICULE DE BREVET EUROPEEN

(11) **EP 1 319 119 B1**
(45) Date de publication et mention de la délivrance du brevet: **26.04.2006**
(21) Numéro de dépôt: 01972149.7
(22) Date de dépôt: 12.09.2001
(51) Int. Cl.: F01L 9/04

(54) **DISPOSITIF DE CONNEXION POUR L'ACHEMINEMENT DE SIGNAUX DE COMMANDE ET DE PUISSANCE VERS DES ACTIONNEURS DE SOUPAPES D'UN MOTEUR A COMBUSTION INTERNE**
VORRICHTUNG ZUM VERBINDEN UND ZUM ÜBERTRAGEN DER SIGNALE UND DER LEISTUNG ZU EINEM VENTILAKTUATOR EINER BRENNKRAFTMASCHINE
CONNECTING DEVICE FOR ROUTING CONTROL AND POWER SIGNALS TO AN INTERNAL COMBUSTION ENGINE VALVE ACTUATORS

(30) Priorité: 19.09.2000 FR 0011918
(43) Date de publication de la demande: 18.06.2003
(73) Titulaire: Valeo Systemes de Controle Moteur, 95520 Osny (FR)
(72) Inventeur: HOCHE, Jean, F-76800 Saint-Etienne du Rouvray (FR)
(74) Mandataire: Fruchard, Guy
(86) Numéro de dépôt international: PCT/FR2001/002832
(87) Numéro de publication internationale: WO 2002/025070

(56) Documents cités:
- EP-A- 0 869 261
- DE-A- 19 756 095
- DE-A- 19 756 342

## Description

La présente invention est relative à un dispositif permettant d'acheminer des signaux de commande et de puissance vers des actionneurs de soupapes d'un moteur à combustion interne.

Elle vise plus particulièrement un dispositif de connexion pour équiper un moteur « camless » (sans arbre à came), essence, diesel ou au gaz, pourvu d'une pluralité de soupapes tant à l'échappement qu'à l'admission.

Compte tenu des nouvelles réglementations législatives en matière de sauvegarde et de respect de l'environnement imposées par les différents Etats, les constructeurs automobiles ont été amenés à concevoir des moteurs à combustion interne à rejet polluant minimal.

Dans le cadre de cette recherche de l'amélioration des paramètres de la combustion d'un moteur à explosion et donc globalement de son rendement, les constructeurs automobiles, par la voie de leur motoriste, ont développé des perfectionnements apportés à la commande et au pilotage des soupapes d'admission et ou d'échappement.

Dans cette optique, les traditionnelles commandes de soupapes par le biais de culbuteurs, d'arbres à cames, dont le mouvement était assuré par une chaîne, puis par une courroie, ont été supprimées en totalité ou en partie, au profit d'une solution dite « camless ».

La technologie « camless » utilise des actionneurs pneumatiques (automobile de compétition, disposant d'un moteur à très haut rendement, typiquement moteur de Formule 1) ou électromagnétiques (automobile de très grande série) pour piloter et commander la course des soupapes en fonction du cycle moteur. Ces actionneurs sont généralement positionnés dans la continuité des queues de soupapes et doivent être rendus solidaires de la culasse, afin que les solénoïdes puissent déplacer en translation dans un sens ou dans l'autre la soupape ainsi équipée.

En pratique, l'actionneur dispose généralement d'un circuit de puissance et d'un circuit de commande. Le circuit de puissance est destiné à apporter l'énergie électrique nécessaire à la commutation du solénoide et met donc en oeuvre une puissance électrique conséquente (30 à 40 A sous 38 V), tandis que le circuit de commande est nécessaire au calculateur électronique pour appréhender la position ouverte, ou fermée, ou une position intermédiaire entre ces eux états, de la soupape. Les signaux, dans ce dernier cas, sont dits des « signaux faibles » et mettent en oeuvre des intensités de courant nettement plus faibles que les précédentes.

Par ailleurs, la liaison entre les actionneurs et le calculateur électronique est à l'heure actuelle effectuer par des fils, ceux-ci étant au nombre d'au moins quatre par actionneurs, deux d'entre eux présentant en plus une section appropriée au passage d'un courant d'intensité importante.

Pour un moteur classique de quatre cylindres, disposant de quatre soupapes par cylindre (donc quatre actionneurs par cylindre), le faisceau de câbles nécessaire à son fonctionnement peut atteindre un toron de plusieurs centimètres de diamètre, ce qui le rend difficilement manipulable et intégrable dans le compartiment moteur.

De plus, les fils formant le toron disposent à chacune de leur extrémité d'une connectique importante en nombre, ce qui augmente d'autant les risques d'erreur de montage et/ou de dysfonctionnement du moteur.

En outre, la présence au sein de ces torons de fils pour des courants forts (plusieurs dizaines d'ampères) entrelacés avec des fils pour des courants faibles (quelques dixièmes d'ampères à quelques ampères) risquent d'affecter, en raison de phénomène de parasitage, ou de défaut de blindage, les signaux de commande.

D'autres paramètres inhérents au fonctionnement d'un moteur à combustion interne peuvent également affecter le fonctionnement correct des actionneurs électromagnétiques. Au titre de leur environnement proche, on note la température élevée de fonctionnement, due à la proximité du moteur, généralement voisine de 100°C, température à partir de laquelle les composants électroniques peuvent être affectés de certains troubles (dérives par exemple), ou encore l'ambiance de brouillard d'huile dans laquelle baignent les actionneurs et leurs différents contacts, l'huile en vieillissant pouvant en plus devenir conductrice et ainsi créer des courts circuits.

La présence de vibrations peut aussi conduire notamment à des troubles de fonctionnement au niveau de la connectique. Des cosses et/ou des connecteurs peuvent présenter des contacts avec jeu, qui induisent un défaut au niveau du contact électrique entre la cosse et le connecteur, voir même, la création d'arcs électriques qui risquent de détériorer les différents contacts.

La présente invention vise à pallier les inconvénients des dispositifs de connexion selon l'art antérieur en proposant un dispositif qui supprime tout risque de dysfonctionnement des actionneurs suite à des défauts de connexion électrique, dans un environnement sévère.

A cet effet, le dispositif permettant l'acheminement électrique de signaux de commande et de puissance à des actionneurs pilotant des soupapes d'un moteur, se caractérise en ce qu'il comporte une plaque métallique, dont chacune des faces longitudinales est revêtue d'un circuit imprimé destiné respectivement aux signaux de commandes et aux signaux de puissance, les pistes de chacun des circuits imprimés cheminant entre des premières et secondes plages de connexion destinées à permettre de réaliser la continuité électrique d'une part, avec un circuit électronique de commande des actionneurs et d'autre part, avec les actionneurs.

Dans des modes de réalisation avantageux, on a notamment recours en outre à l'une et/ou l'autre des dispositions suivantes :
- la plaque est en aluminium ;
- les premières plages de connexion, destinées respectivement aux signaux de commande et aux signaux de puissance des actionneurs, sont situées sur chacune des faces respectives de la plaque et sur un même côté de la plaque ;
- les secondes plages de connexion, destinées respectivement aux signaux de commande et aux signaux de puissance des actionneurs, sont situées sur une même face de la plaque ;
- les secondes plages de connexion sont situées sur la face de la plaque, destinée au circuit imprimé des signaux de puissance ;
- la plaque est pourvue d'une pluralité d'organes de montage avec les actionneurs, ces organes étant positionnés au voisinage d'extrémités dénudées des secondes plages de connexion afin de permettre l'établissement de la continuité électrique par contact élastique avec des plots faisant saillie sur les actionneurs ;
- la plaque est pourvue d'une pluralité d'encoches sur au moins un de ses côtés permettant le passage de parties de circuit imprimé venues de l'une des faces de la plaque sur l'autre face ;
- les pistes du circuit imprimé des signaux de commande sont connectées à des composants discrets, logiques, électroniques, de technologies analogiques ou numériques.

Selon un autre aspect de l'invention, celle-ci concerne un moteur à essence, diesel, ou au gaz, dont l'ensemble des soupapes d'admission et/ou d'échappement sont pilotées par des actionneurs électromagnétiques, dont les signaux électriques de puissance et/ou de commande sont acheminés par un dispositif de connexion tel que visé précédemment.

Selon encore un autre aspect de l'invention, celle-ci vise un véhicule comportant un moteur muni d'un dispositif de connexion tel que visé précédemment.

D'autres caractéristiques et avantages de la présente invention ressortiront de la description faite ci-après, en référence aux dessins annexés qui en illustrent un exemple de réalisation dépourvu de tout caractère limitatif. Sur les figures :

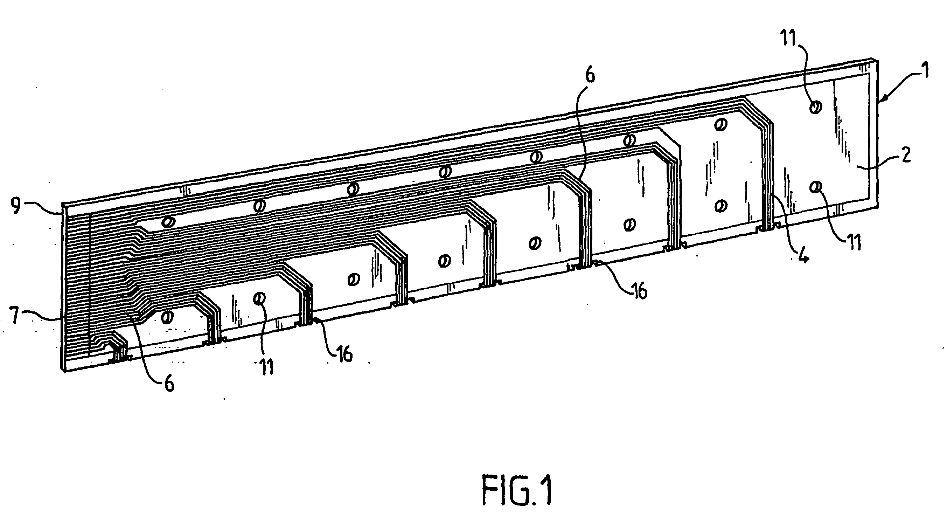

- la figure 1 est une vue en perspective, orientée du côté des signaux de commande, du dispositif selon un mode de réalisation de l'invention ;

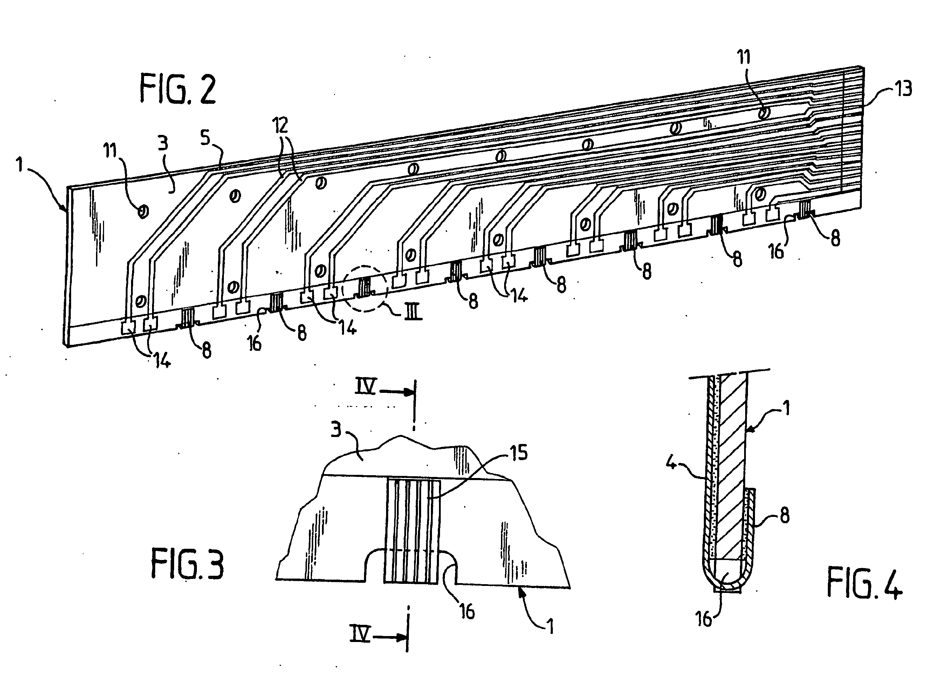

- la figure 2 est une vue en perspective, orientée du côté des signaux de puissance, du dispositif selon un mode de réalisation de l'invention ;
- la figure 3 est une vue de face de la figure 2 illustrant un détail de réalisation ;
- la figure 4 est une vue de côté de la figure 3.

Selon un mode préféré de réalisation du dispositif de connexion, objet de l'invention, celui-ci comporte une plaque 1, réalisée en matériau métallique, préférentiellement en aluminium. Cette plaque 1, dont l'épaisseur est sensiblement voisine de 1 à 1.5 mm, est destinée à servir de substrat à un circuit imprimé double face. Le choix de l'aluminium ou d'un alliage à base d'aluminium est dicté, d'une part, par des considérations de coût très limité, et d'autre part, par des considérations d'ordre techniques.

En raison de ses propriétés mécaniques, la plaque 1 d'aluminium offre une tenue mécanique optimale à la liaison mécanique avec des actionneurs. De plus, l'importance du coefficient de conductibilité thermique de l'aluminium permet à la plaque 1 ainsi réalisée de jouer un rôle de radiateur et ainsi d'évacuer la chaleur provenant soit de l'effet Joule dû au passage de courant dans les conducteurs (néanmoins, on cherchera à minimiser cet effet, par un choix approprié des sections des conducteurs), soit du milieu environnant immédiat de la plaque (chaleur issue du moteur et de ses divers composants).

Les dimensions de cette plaque 1, tant longitudinale que transversale, sont choisies en fonction du type et du nombre d'actionneurs sur lesquels elle doit être montée.

Ainsi, une plaque destinée à équiper un moteur 6 cylindres en ligne, en V, ou un moteur quatre cylindres en ligne, à quatre, trois, ou deux soupapes par cylindre, n'aura pas les mêmes dimensions et son gabarit sera adapté à chacune des configurations moteurs.

Néanmoins, quel que soit le type de moteur, cette plaque 1 est munie, sur chacune de ses faces 2, 3, d'une couche 4, 5 représentant un circuit imprimé isolé double face. Chacune de ces couches 4, 5 est préfabriquée aux dimensions de la plaque 1 et est obtenue à la suite d'opérations de découpage de feuilles contenant une pluralité de circuits, ou à la suite d'une opération de déroulement d'une bobine de circuits imprimés.

Les deux couches 4, 5 de circuits imprimés sont adhérisées sur les faces 2, 3 respectives de la plaque 1 de substrat à l'aide d'une colle possédant d'excellentes propriétés de conductibilité thermique mais isolante électriquement.

Selon une caractéristique de l'invention, chacun des circuits imprimés est dévolu au type de signaux qu'il doit véhiculer.

Ainsi sur l'une 2 des faces 2, 3 du substrat métallique, est disposé le circuit imprimé 4 destiné aux signaux de commande des actionneurs, tandis que sur l'autre face 3 du substrat, est apposé le circuit imprimé 5 destiné aux signaux de puissance des actionneurs.

Bien entendu, le circuit imprimé est conçu en fonction de sa destination finale. Notamment, le circuit imprimé destiné aux signaux de commande 4 comporte une pluralité de pistes 6 qui s'étendent notamment selon l'axe principale de la plaque dans sa direction longitudinale entre des premières plages de connexion 7 et des secondes plages de connexion 8 situées sur la plaque 1.

Les premières plages de connexion 7 sont destinées à être connectées par exemple au circuit électronique (non représenté sur les figures) pilotant les actionneurs et présentent au niveau de leurs extrémités des premières parties dénudées pour permettre un appui élastique avec les contacts venus de la connectique reliée au circuit électronique. Ces premières plages de connexion 7 se trouvent rapportées sur l'un des bords 9 de la plaque 1.

Les secondes plages de connexion 8 sont destinées à être reliés aux diverses bornes électriques des actionneurs. De manière similaire aux premières plages de connexion 7, les extrémités des diverses pistes sont dénudées ou du moins la matière isolante protégeant la piste conductrice est ôtêe, afin de garantir un appui élastique et la continuité électrique avec des plots appartenant aux actionneurs, ceux-ci se trouvant en regard des secondes plages de connexion 8.

Les pistes 6 du circuit imprimé 4 destinées aux signaux de commande présentent des dimensions, et notamment une largeur et.une épaisseur de conducteurs, compatibles avec les caractéristiques électriques des signaux.

En variante, les pistes 6 du circuit imprimé 4 des signaux de commande peuvent être connectées à des composants discrets, logiques, électroniques, de technologies analogiques ou numériques, ces composants permettant de piloter et/ou de commander, suivant diverses lois établies par le motoriste, les actionneurs et donc les soupapes qui leurs sont solidaires.

S'agissant ici de signaux de faibles puissances, la largeur de ces pistes sera de l'ordre de 0,5mm pour une épaisseur sensible voisine de 70 *µ*m. Ces dimensions permettent de faire cheminer les pistes 6 sur toute la surface du substrat et de délimiter grâce à une pluralité de circonvolutions entre des diverses zones du substrat et notamment celles qui sont destinées à la solidarisation avec les actionneurs. En effet, ces zones sont pourvues d'une pluralité d'organes de montages 11 tels que notamment des orifices qui permettent le passage d'organes de serrages avec les actionneurs et doivent donc être dépourvues de tout passage de pistes de circuit imprimé.

Selon une autre caractéristique de l'invention l'autre face 3 du substrat 1 est destinée au circuit imprimé 5 des signaux de puissance des actionneurs.

Les pistes 12 du circuit imprimé 5 figurant les signaux de puissance cheminent sur la surface 3 du substrat 1 entre des premières 13 et secondes 14 plages de connexion.

Les extrémités libres de ces pistes 12 de signaux de puissance, au niveau des premières 13 et secondes 14 plages de connexion, sont dénudées ou du moins la couche de matière isolante est ôtée, mettant les pistes à nu pour permettre l'établissement de liaison électrique à la suite de contacts élastiques provenant d'une part, du montage des actionneurs sur la plaque 1, et d'autre part, de la liaison avec la connectique distribuant les signaux de puissance au circuit imprimé.

L'architecture du circuit imprimé 5 des signaux de puissance est similaire à celle du circuit imprimé 4 des signaux de commande. Les pistes 12 cheminent sur l'ensemble de la surface 3 du substrat entre les premières 13 et secondes 14 plages de connexion, en évitant les organes de montage 11 destinés au maintien des actionneurs mais diffèrent simplement au niveau de leurs dimensions caractéristiques. En particulier, les pistes 12 doivent véhiculer des signaux de puissance électrique importante (30 à 40 A sous 38 V) et leur section droite est donc adaptée en conséquence (la largeur de chacune des pistes est de l'ordre de 4 mm, et l'épaisseur peut atteindre 140 *µ*m par exemple). De plus, pour éviter des phénomènes de bruit, ou d'inductance, l'écartement entre chacune des pistes sera singulièrement augmenté par rapport à l'écartement entre les pistes formant le circuit de commande.

Selon encore une autre caractéristique de l'invention, les premières plages de connexion 7, 13 respectives des circuits imprimés de puissance 5 et de commande 4 sont situées sur le même bord 9 du substrat 1, de chaque côté de celui-ci, de manière à permettre l'établissement d'une liaison électrique avec chacun des circuits imprimés 4, 5 à partir d'un seul connecteur.

Par ailleurs, afin de faciliter le montage des actionneurs sur la plaque, et notamment que l'ensemble des contacts élastiques nécessaires au fonctionnement des actionneurs soit alimenté, les deuxièmes plages de connexion 8 des signaux de commande sont ramenés sur la même face 3 du substrat 1 et notamment sur celle comportant le circuit imprimé 5 des signaux de puissance.

A cet effet, les extrémités 15 des parties flexibles du circuit imprimé 4 destiné aux signaux de commande sont acheminées vers au moins un des côtés de la plaque 1 au niveau d'une pluralité d'encoches 16.

Ces encoches 16 facilitent le passage des parties flexibles 15 d'une face à l'autre de la plaque 1 et évitent que celles-ci ne soient endommagées par le pincement de la partie flexible 15 sur la tranche de la plaque 1. Après passage de ces encoches 16, les parties flexibles 15 sont adhérisées sur la face 3 de la plaque 1.

Le montage du dispositif de connexion selon l'invention est le suivant :
- on solidarise les actionneurs sur la culasse du moteur en reliant leurs parties mobiles aux queues de soupapes respectives ;
- la plaque 1 est positionnée face à l'ensemble des actionneurs, en prenant soin de placer en regard des contacts électriques faisant saillie des actionneurs les deuxièmes plages de connexion 8, 14 ;
- on solidarise la plaque 1 sur les actionneurs au moyen de la pluralité d'organes de montage 11, la continuité électrique est réalisée par contact élastique entre les secondes plages de connexion 8, 14 et les contacts venus des actionneurs ;
- on relie les premières plages de connexion 7, 13 à un connecteur en forme de broche ou analogue, ce dernier faisant la liaison avec un boîtier électronique pilotant les actionneurs.

L'invention telle que décrite précédemment offre de multiples avantages :
Elle évite des liaisons par fils et par connecteurs qui sont volumineux et peu fiables, tout en permettant une évacuation thermique et un isolement électrique entre les courants forts et les courants faibles.
Il demeure bien entendu que la présente invention n'est pas limitée aux exemples de réalisation décrits et représentés ci-dessus, mais au contraire qu'elle en englobe toutes les variantes.

## Revendications

1. Dispositif permettant l'acheminement électrique de signaux de commande et de puissance à des actionneurs pilotant des soupapes d'un moteur, **caractérisé en ce qu'**il comporte une plaque métallique (1), dont chacune des faces (2, 3) longitudinales est revêtue d'un circuit imprimé (4, 5) destiné respectivement aux signaux de commandes et aux signaux de puissance, les pistes (6, 12) de chacun des circuits imprimés (4, 5) cheminant entre des premières (7, 13) et secondes (8, 14) plages de connexion destinées à permettre de réaliser la continuité électrique d'une part, avec un circuit électronique de commande des actionneurs et d'autre part, avec les actionneurs.

2. Dispositif selon la revendication 1, dans lequel la plaque (1) est en aluminium.

3. Dispositif selon l'une des revendications 1 ou 2, dans lequel les premières plages de connexion (7, 13), destinées respectivement aux signaux de commande et aux signaux de puissance des actionneurs, sont situées sur chacune des faces respectives (2, 3) de la plaque (1) et sur un même côté (9) de la plaque(1).

4. Dispositif selon l'une des revendications 1 ou 2, dans lequel les secondes plages de connexion (8, 14), destinées respectivement aux signaux de commande et aux signaux de puissance des actionneurs, sont situées sur une même face de la plaque (1).

5. Dispositif selon la revendication 4, dans lequel les secondes plages de connexion (8, 14) sont situées sur la face de la plaque (1), destinée au circuit imprimé (5) des signaux de puissance.

6. Dispositif selon l'une quelconque des revendications 1 à 5, dans lequel la plaque (1) est pourvue d'une pluralité d'organes de montage (11) avec les actionneurs, ces organes étant positionnés au voisinage d'extrémités dénudées des secondes plages de connexion (8, 14) afin de permettre l'établissement de la continuité électrique par contact élastique avec des plots faisant saillie sur les actionneurs.

7. Dispositif selon l'une quelconque des revendications 1 à 6, dans lequel la plaque (1) est pourvue d'une pluralité d'encoches (16) sur au moins un de ses côtés permettant le passage de parties (15) de circuit imprimé (4) venues de l'une des faces de la plaque (1) sur l'autre face de la plaque.

8. Dispositif selon l'une quelconque des revendications 1 à 7, dans lequel les pistes (6) du circuit imprimé (4) des signaux de commande sont connectées à des composants discrets, logiques, électroniques, de technologies analogiques ou numériques.

9. Moteur à essence, diesel, ou au gaz, dont l'ensemble des soupapes d'admission et/ou d'échappement sont pilotées par des actionneurs électromagnétiques, dont les signaux électriques de puissance et/ou de commande sont acheminés par un dispositif de connexion selon l'une quelconque des revendications 1 à 8.

10. Véhicule comportant un moteur selon la revendication 9.

## Claims

1. A device for conveying electrical control and power signals to actuators driving valves of an engine, the device being **characterized in that** it comprises a metal plate (1) having each of its longitudinal faces (2, 3) covered by a respective printed circuit (4, 5) serving respectively for control signals and for power signals, the tracks (6, 12) of each of the printed circuits (4, 5) extending between first and second connection areas (7, 13 and 8, 14) for providing electrical continuity firstly with an electronic circuit for controlling the actuators, and secondly with the actuators.

2. A device according to claim 1, in which the plate (1) is made of aluminum.

3. A device according to claim 1 or claim 2, in which the first connection areas (7, 13) intended respectively for the control signals and for the actuator power signals are situated on each of respective faces (2, 3) of the plate (1) and on a common side (9) of the plate (1).

4. A device according to claim 1 or claim 2, in which the second connection areas (8, 14) intended respectively for the control signals and for the actuator power signals, are situated on a common face of the plate (1).

5. A device according to claim 4, in which the second connection areas (8, 14) are situated on the face of the plate (1) that is for being covered by the printed circuit (5) for the power signals.

6. A device according to any one of claims 1 to 5, in which the plate (1) is provided with a plurality of assembly members (11) for assembling to the actuators, these members being positioned in the vicinity of bare ends of the second connection areas (8, 14) in order to enable electrical continuity to be established by electrical contact with studs projecting from the actuators.

7. A device according to any one of claims 1 to 6, in which the plate (1) is provided with a plurality of notches (16) in at least one of its sides serving to pass portions (15) of the printed circuit (4) from one of the faces of the plate (1) to the other face of the plate.

8. A device according to any one of claims 1 to 7, in which the tracks (6) of the printed circuit (4) for the control signals are connected to discrete electronic logic components using analog or digital technologies.

9. A petrol, diesel, or gas engine in which all of the admission and/or exhaust valves are controlled by electromagnetic actuators, for which the electrical power and/or control signals are conveyed by a connection device according to any one of claims 1 to 8.

10. A vehicle including an engine according to claim 9.

## Patentansprüche

1. Vorrichtung, welche die elektrische Weiterleitung von Steuer- und Leistungssignalen an Aktuatoren ermöglicht, welche die Ventile eines Motors steuern, **dadurch gekennzeichnet, dass** sie eine Metallplatte (1) umfasst, deren jeweilige Längsflächen (2, 3) mit einer gedruckten Schaltung (4, 5) versehen sind, die für Steuersignale bzw. Leistungssignale bestimmt ist, wobei die Bahnen (6, 12) jeder gedruckten Schaltung (4, 5) zwischen ersten Verbindungsbereichen (7, 13) und zweiten Verbindungsbereichen (8, 14) verlaufen, die dazu bestimmt sind, die elektrische Kontinuität mit einem elektronischen Steuerschaltkreis zum Steuern der Aktuatoren einerseits und mit den Aktuatoren andererseits herstellen zu können.

2. Vorrichtung nach Anspruch 1, bei der die Platte (1) aus Aluminium ist.

3. Vorrichtung nach einem der Ansprüche 1 oder 2, bei der sich die ersten Verbindungsbereiche (7, 13), die für die Steuersignale bzw. die Leistungssignale der Aktuatoren bestimmt sind, auf jeder der jeweiligen Flächen (2, 3) der Platte (1) und auf einer gleichen Seite (9) der Platte (1) befinden.

4. Vorrichtung nach einem der Ansprüche 1 oder 2, bei der sich die zweiten Verbindungsbereiche (8, 14), die für die Steuersignale bzw. die Leistungssignale der Aktuatoren bestimmt sind, auf einer gleichen Fläche der Platte (1) befinden.

5. Vorrichtung nach Anspruch 4, bei der sich die zweiten Verbindungsbereiche (8, 14) auf der Fläche der Platte (1) befinden, die für die gedruckte Schaltung (5) für die Leistungssignale bestimmt ist.

6. Vorrichtung nach einem der Ansprüche 1 bis 5, bei der die Platte (1) mit einer Vielzahl von Montageelementen (11) zur Montage mit den Aktuatoren versehen ist, wobei diese Elemente nahe den freigelegten Enden der zweiten Verbindungsbereiche (8, 14) positioniert sind, um das Herstellen der elektrischen Kontinuität durch elastischen Kontakt mit an den Aktuatoren vorstehenden Kontaktstücken zu ermöglichen.

7. Vorrichtung nach einem der Ansprüche 1 bis 6, bei der die Platte (1) an mindestens einer ihrer Seiten mit einer Vielzahl von Einkerbungen (16) versehen ist, die den Durchtritt von Teilen (15) der gedruckten Schaltung (4) ermöglicht, die sich von einer der Flächen der Platte (1) auf die andere Fläche der Platte erstrecken.

8. Vorrichtung nach einem der Ansprüche 1 bis 7, bei der die Bahnen (6) der gedruckten Schaltung (4) für die Steuersignale mit diskreten, logischen, elektronischen Komponenten in analoger oder digitaler Technologie verbunden sind.

9. Benzin-, Diesel- oder Gasmotor, dessen Gesamtheit von Einlass- und/oder Auslassventilen von elektromagnetischen Aktuatoren gesteuert wird, deren elektrische Leistungssignale und/oder Steuersignale von einer Verbindungsvorrichtung nach einem der Ansprüche 1 bis 8 weitergeleitet werden.

10. Fahrzeug umfassend einen Motor nach Anspruch 9.
